# EUROPÄISCHE PATENTANMELDUNG

(11) **EP 1 001 669 A2**
(43) Veröffentlichungstag der Anmeldung: **17.05.2000**
(21) Anmeldenummer: 99118906.9
(22) Anmeldetag: 24.09.1999
(51) Int. Cl.: H05K 7/14, H05K 9/00

(54) **Baugruppenträger**

(30) Priorität: 09.11.1998 DE 19851589
(71) Anmelder: VERO Electronics GmbH, 28279 Bremen (DE)
(72) Erfinder: Borschewski, Dietmar, 28197 Bremen (DE); Schröder, Rainer, 27721 Ritterhude (DE)
(74) Vertreter: Bohnenberger, Johannes, Dr.

(57) **Zusammenfassung**

Die Erfindung betrifft einen Baugruppenträger, insbesondere ein 19"-Gehäuse, mit einer ersten Seitenwand (2), einer zweiten Seitenwand, einer Rückwand, einer oberen Abdeckung (5) und einer unteren Abdeckung, wobei mindestens zwischen einer der Abdeckungen und der an der Abdeckung (5) angrenzenden ersten Seitenwand (2) eine HF-Dichtung (4) vorgesehen ist.

Um bei einem HF-dichten Baugruppenträger ohne großen Aufwand, z. B. durch Service-Personal bei elektrischen Messungen, einen Zugriff in den Baugruppenträger zu ermöglichen, ist erfindungsgemäß vorgesehen, die erste Seitenwand mit einer nach oben hin und/oder nach unten hin offenen Rinne (3) zu versehen, wobei die HF-Dichtung (4) von der Rinne (3) gehalten ist.

## Beschreibung

Die Erfindung betrifft einen Baugruppenträger, insbesondere ein 19"-Gehäuse, entsprechend dem Oberbegriff des Anspruchs 1.

Üblicherweise werden solche Baugruppenträger zusammen mit weiteren Baugruppenträgern in dem Baugruppenträger angepaßte Gestelle oder Schränke über- und auch nebeneinander eingebaut. In den Baugruppenträger sind üblicherweise Leiterplatten untergebracht, die mit elektronischen Bauelementen versehen sind.

Insbesondere, wenn in einem solchen Baugruppenträger HF-empfindliche elektronische Bauelemente untergebracht sind oder umgekehrt HF-Strahlung abgebende Bauelemente vorgesehen sind, ist es wichtig, dag der Baugruppenträger eine gute HF-Abschirmung aufweist, um eine negative Beeinflußung der in dem Baugruppenträger vorgesehenen elektronischen Bauelemente durch äußere HF-Strahlung zu vermeiden bzw. umgekehrt innerhalb des Baugruppenträgers vorhandene HF-Strahlung nach außen hin, zum Schutz in der Nähe befindlicher elektronischer Schaltkreise, abzuschirmen.

Aus der DE-C1-42 05 893 ist ein Baugruppenträger gemäß dem Oberbegriff des Anspruchs 1 bekannt.

Um ohne Verschlechterung der Montage mit einfachen Mitteln einen an allen Seiten HF-dicht verschlossenen Baugruppenträger zu schaffen, wird vorgeschlagen, die in dem bekannten Baugruppenträger vorhandenen Querschienen zur Halterung der Seitenwände mit einem Befestigungsflansch zu versehen, auf den HF-Dichtungsstreifen oben aufgelegt werden. Nachfolgend werden Befestigungsflansche der Rückwand des Baugruppenträgers mit den Befestigungsflanschen der Querschienen verbunden, wobei die HF-Dichtungsstreifen eine Verbesserung der HF-Abschirmung im Verbindungsbereich herbeiführen sollen.

An dem bekannten, mit HF-Dichtungsstreifen versehenen Baugruppenträger ist insbesondere nachteilhaft, daß dessen obere Abdeckung nach der Montage des Baugruppenträgers nur mit erheblichem Zeitaufwand demontiert werden kann, wobei zudem etwaig in dem bekannten Baugruppenträger vorhandene Steckkarten vorab entfernt werden müssen. Ferner kommt es bei der Demontage der Abdeckung, z. B. zu Reparaturzwecken oder zur Durchführung einer Messung mit einem Meßgerät etc., unweigerlich zu einer Beschädigung der HF-Dichtungsstreifen. Um den bekannten Baugruppenträger erneut verwenden zu können, ist dann eine aufwendige und sorgfältige Entfernung sämtlicher Bestandteile der beschädigten HF-Dichtungsstreifen nötig, bevor neue Dichtungsstreifen - wiederum unter erheblichem Zeitaufwand - aufgeklebt werden können.

Daher liegt der Erfindung die Aufgabe zugrunde, einen HF-dichten Baugruppenträger der eingangs genannten Art dahingehend weiterzubilden, daß bei geringem Zeitaufwand ein Zugriff in das Innere des Baugruppenträgers ermöglicht ist.

Diese Aufgabe wird bei einem gattungsgemäßen Baugruppenträger durch die im Kennzeichen des Patentanspruchs 1 angegebenen Merkmale gelöst.

Ein wesentlicher Aspekt der Erfindung besteht darin, jede der zwei Seitenwände im Bereich der oberen Abdeckung mit einer im wesentlichen waagerechten, sich vorzugsweise über die gesamte Breite erstreckende, nach oben offene Rinne oder dergleichen zu versehen und in die Rinne eine der Rinne angepaßte HF-Dichtung einzulegen. Im Bereich der Seitenwände ist die Abdeckung mit jeweils einer Auflageschiene versehen, deren Materialstärke etwa der Breite der Rinne entspricht oder geringfügig größer ist. Wird nun die obere Abdeckung auf die beiden Seitenwände des Baugruppenträgers montiert, so liegt die Unterfläche jeder Auflageschiene jeweils auf einer HF-Dichtung auf und die vorzugsweise an der Innenseite der Seitenwand verlaufende Rinne klemmt gegebenenfalls die Auflageschiene der oberen Abdeckung in geeignetem Maße ein, so daß die Abdeckung zuverlässig gehalten wird und dennoch leicht von Service-Personal, z. B. bei der Durchführung von elektrischen Messungen innerhalb des Baugruppenträgers, ohne Mühe und dem Entfernen von Schrauben von dem Baugruppenträger abgehoben werden kann. Selbst wenn keine Klemmverbindung zwischen der Auflageschiene und der Rinne vorgesehen ist, wird der sogenannte EMV-Kontakt allein schon durch das Eigengewicht der Abdeckung hergestellt, die auf der HF-Dichtung bzw. dem sogenannten EMV-Dichtmaterial aufliegt.

Von Vorteil ist zudem, daß die Abdeckung bei ihrem Entfernen nicht an dem Dichtmaterial entlangkratzt und dieses beschädigt.

Bei den HF-Dichtungen bzw. dem EMV-Dichtmaterial kann es sich beispielsweise um Kupfer oder Kupferberyllium und dergleichen oder auch um eine HF-Dichtung aus elektrisch leitendem elastischen Material, wie beispielsweise elektrisch leitendem Silikon-Elastomer. Gegebenenfalls können diese auch bei Verwendung eines geeigneten Klebers selbstklebend sein oder mit einem für HF-Anwendungen geeigneten Kleber in die Rinne eingeklebt werden. Vorzugsweise wird die HF-Dichtung jedoch in die Rinne eingeklemmt, wobei die HF-Dichtung einen etwas größeren Querschnitt als die klemmende Rinne aufweist.

Insbesondere, wenn es sich bei der HF-Dichtung um eine elastische Dichtung handelt, ist diese in der Lage, etwaige Unebenheiten, wie z. B. durch ungleichmäßiges Aufschieben der Abdeckung etc., auszugleichen.

Weitere vorteilhafte Ausführungsformen der Erfindung sind in den Unteransprüchen angegeben.

Die Erfindung wird nachfolgend anhand von nicht notwendigerweise maßstäblichen Zeichnungen näher beschrieben, wobei gleiche oder gleich wirkende Teile mit denselben Bezugszeichen versehen sind und darum nicht nochmals näher erläutert werden. Es zeigen:
- Fig. 1: die Seitenwand eines Baugruppenträgers mit einer darüber befindlichen HF-Dichtung und einer oberen Abdeckung unmittelbar vor dem Zusammenfügen der Seitenwand mit der oberen Abdeckung, in Form einer perspektivischen Darstellung;
- Fig. 2: den mit Y in Fig. 1 bezeichneten Ausschnitt ebenfalls in einer perspektivischen Darstellung; und
- Fig. 3: die Situation nach dem Zusammenfügen der oberen Abdeckung mit der Seitenwand des erfindungsgemäßen Baugruppenträgers, in einer perspektivischen Darstellung.

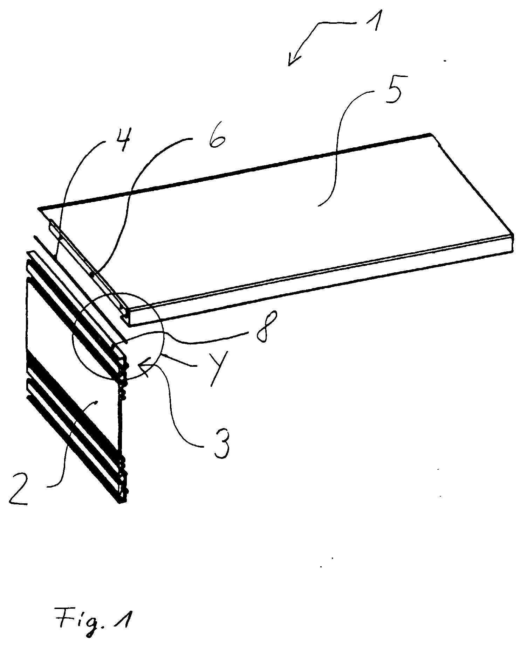

Fig. 1 zeigt einen Baugruppenträger 1 mit einer linken Seitenwand 2, einer Auflagerinne 3, einer HF-Dichtung bzw. EMV-Dichtung 4, eine obere Abdeckung 5, eine an der oberen Abdeckung vorgesehene Auflageschiene 6, wobei die Auflageschiene mit einem Bohrloch 7 versehen ist und das Bezugszeichen 8 das obere nach außen abgewinkelte Ende der Seitenwand 1 bezeichnet.

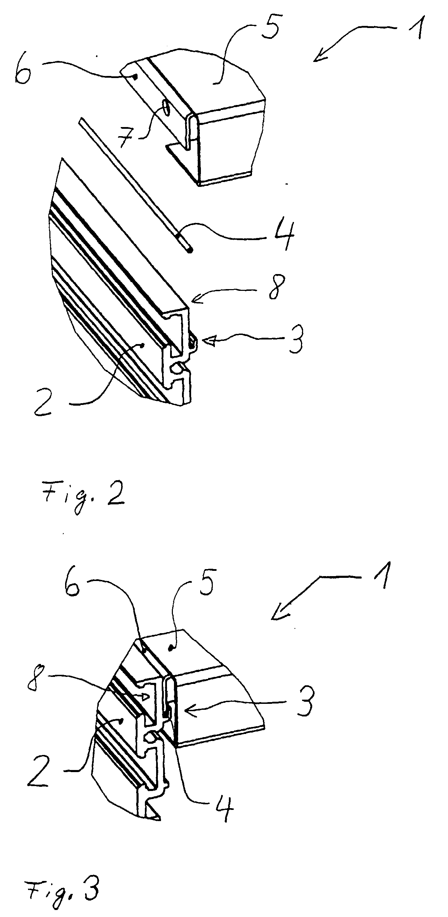

Fig. 2 zeigt die Situation vor dem Zusammenfügen der Seitenwand 2 mit der oberen Abdeckung 5 im Detail (Ausschnitt Y in Fig. 1). An dem oberen Ende der Seitenwand 2 ist eine weitgehend parallel zur Oberseite der Seitenwand 2 verlaufende Auflagerinne 3 einstückig auf der in Richtung des Inneren des Baugruppenträgers 1 weisenden Seite einstückig angeformt. Bei der in Fig. 2 angedeuteten Montage wird die stabförmige HF-Dichtung 4 in die Rinne 3 eingedrückt und von der Rinne 3 klemmend gehalten. Sowohl die Rinne 3 als auch die HF-Dichtung 4 erstreckt sich weitgehend über die gesamte Breite der Seitenwand 2.

Nachfolgend wird die Abdeckung 5 auf den Baugruppenträger 1 aufgelegt und die Auflageschiene 6, bei der es sich um ein gegenüber der ebenen Oberseite der Abdeckung 5 senkrecht nach unten abgewinkeltes, einstückig an die Abdeckung 5 angeformtes Profil handelt, liegt auf der sich in der Rinne 3 befindlichen HF-Dichtung 4 mit seiner Unterseite auf. Die Unterseite gelangt in die Rinne 3, so daß die Abdeckung 5 und mit ihr die Auflageschiene 6 angehoben werden müßte, um aus dem Eingriffsbereich der Rinne zu gelangen. Hierdurch wird sichergestellt, daß die Auflageschiene 6 nicht seitlich aus der Rinne herausrutschen kann.

In Fig. 3 ist schließlich die auf die Seitenwand montierte bzw. aufgelegte obere Abdeckung 5 dargestellt, wobei sichtbar ist, dag die Auflageschiene 6 unter Zwischenlage der HF-Dichtung 4 sicher in der Auflagerinne 3 liegt und einen HF-dichten Abschluß bildet.

Es versteht sich, daß eine solche Anordnung auch an dem anderen seitlichen Ende der oberen Abdeckung 5 mit der weiteren Seitenwand (nicht dargestellt) bei dem erfindungsgemäßen Baugruppenträger vorgesehen ist. In analoger Weise kann ebenfalls ein HF-dichter Abschluß zwischen der Seitenwand 2 und einer unteren Abdeckung (nicht dargestellt) durch eine weitere Auflagerinne (nicht dargestellt) im unteren Bereich der Seitenwand und mit einer Öffnung, die entgegengesetzt zur oberen Auflagerinne 3 ist, unter Zwischenlage einer weiteren HF-Dichtung (nicht dargestellt) vorgesehen sein, wenn es zweckmäßig ist. In Abhängigkeit von den konkreten Einsatzbedingungen des Baugruppenträgers kann die obere Abdeckung 5 und gegebenenfalls auch die untere Abdeckung zusätzlich mit der Seitenwand 2 durch Blechschrauben oder dergleichen verschraubt werden, wobei in der Seitenwand in Höhe der Auflageschiene 6 Bohrlöcher vorgesehen sind, die mit Bohrlöchern in der Auflageschiene 6, wie Bohrloch 7, die einen geringeren Durchmesser aufweisen, fluchten. Eine solche Verbesserung der Befestigung kann beispielsweise sinnvoll sein, wenn der erfindungsgemäße Baugruppenträger in einem Fahrzeug oder dergleichen Verwendung findet. Obwohl es dann etwas aufwendiger ist, die Abdeckung zu demontieren, bleibt insbesondere der Vorteil erhalten, daß die HF-Dichtungen in den Auflagerinnen der Seitenwände beim Abheben der Abdeckung nicht verkratzen oder beschädigt werden.

### Bezugszeichenliste

- 1: Teilansicht eines Baugruppenträgers
- 2: Seitenwand
- 3: Auflagerinne
- 4: HF-Dichtung bzw. EMV-Dichtmaterial
- 5: Abdeckung
- 6: Auflageschiene
- 7: Bohrloch
- 8: oberes Ende der Seitenwand 1

## Patentansprüche

1. Baugruppenträger, insbesondere ein 19"-Gehäuse, mit einer ersten Seitenwand (2), einer zweiten Seitenwand, einer Rückwand, einer oberen Abdeckung (5) und einer unteren Abdeckung, wobei mindestens zwischen einer der Abdeckungen und der an der Abdeckung (5) angrenzenden ersten Seitenwand (2) eine HF-Dichtung (4) vorgesehen ist,
**dadurchgekennzeichnet,**
daß
- die erste Seitenwand eine nach oben hin und/oder nach unten hin offene Rinne (3) aufweist, wobei
- die HF-Dichtung (4) von der Rinne (3) gehalten ist.

2. Baugruppenträger nach Anspruch 1,
**dadurchgekennzeichnet,**
dag eine Seitenwand der Rinne (3) durch die Innenseite der ersten Seitenwand (2) gebildet ist.

3. Baugruppenträger nach Anspruch 1 oder 2,
**dadurchgekennzeichnet,**
dag die Rinne (3) einstückig an die Innenseite der ersten Seitenwand (2) angeformt ist.

4. Baugruppenträger nach einem der Ansprüche 1 bis 3,
**dadurchgekennzeichnet,**
daß die HF-Dichtung (4) in der Rinne (3) eingeklemmt ist.

5. Baugruppenträger nach einem der Ansprüche 1 bis 4,
**dadurchgekennzeichnet,**
daß die Abdeckung (5) im Bereich der ersten Seitenwand (2) eine Auflageschiene (6) aufweist, die auf der von der Rinne (3) getragenen HF-Dichtung (4) aufliegt.

6. Baugruppenträger nach Anspruch 5,
**dadurchgekennzeichnet,**
daß die Auflageschiene (6) und mit ihr die Abdeckung (5) von der Rinne (3) gehalten und die Auflageschiene (6) in der Rinne (3) eingeklemmt ist.

7. Baugruppenträger nach einem der Ansprüche 1 bis 6,
**dadurchgekennzeichnet,**
dag die Rinne (3) einen halbkreisförmigen oder ovalen Querschnitt aufweist.

8. Baugruppenträger nach einem der Ansprüche 1-7,
**dadurchgekennzeichnet,**
daß die HF-Dichtung (4) einen Querschnitt aufweist, der weitgehend dem Querschnitt der Rinne (3) entspricht.

9. Baugruppenträger nach einem der Ansprüche 1 bis 6 oder 8,
**dadurchgekennzeichnet,**
daß die Rinne (3) einen dreieckförmigen, viereckförmigen oder mehreckförmigen Querschnitt aufweist und die HF-Dichtung (4) einen Querschnitt aufweist, der weitgehend der Form des Querschnitts der Rinne (3) entspricht.

10. Baugruppenträger nach einem der vorhergehenden Ansprüche,
**dadurchgekennzeichnet,**
dag die Länge der HF-Dichtung (4) im wesentlichen der Breite der Seitenwand (2) entspricht.
